# EUROPEAN PATENT APPLICATION

(11) **EP 2 186 920 A1**
(43) Date of publication of application: **19.05.2010**
(21) Application number: 08167290.9
(22) Date of filing: 22.10.2008
(51) Int. Cl.: C23C 14/24, C23C 16/448, C30B 23/06

(54) **Arrangement and method for regulating a gas stream or the like**

(71) Applicant: Applied Materials, Inc., Santa Clara, CA 95054 (US)
(72) Inventor: Dieguez-Campo, Manuel, 63457, Hanau (DE); Sommer, Elisabeth, 63755, Alzenau (DE); Martini, Marcel, 63457, Hanau (DE); Ries, Florian, 63825, Westerngrund (DE)
(74) Representative: Schickedanz, Willi

(57) **Abstract**

An arrangement for the regulation of a gas stream or the like is provided, which comprises at least one vaporizer crucible (11) for the vaporization of a material or at least one supply container (37) with material vapor. The vaporized material or the material vapor is conducted via a vapor conduit (7, 10) to a substrate (6). The at least one vaporizer crucible (11) or the at least one supply container (37) is connected via a dosing pipe (16, 40, 41) with the vapor conduit (7, 10). A tappet (17, 46, 47) projects into the dosing pipe (16, 40, 41). By means of a regulator (21) the position of the tappet (17, 46, 47) in the dosing pipe (16, 40, 41) is regulated as a function of a measured variable.

## Description

The invention relates to an arrangement according to the preamble of patent claim 1 as well as to a method according to claim 19.

In the coating of substrates with certain substances, the substances are converted into a gaseous state and subsequently supplied to the substrate. For example, the substances can be heated in a crucible and vaporized. The vapor is subsequently, for example via guide elements, conducted to the substrate.

EP 1 672 715 A1 discloses an arrangement for coating a substrate, which arrangement comprises a vaporizer source, a vapor guide device and a mechanical vapor block in the vapor guide device. The vapor block is herein implemented as a valve comprised of quartz. This valve can be opened or closed.

Furthermore is known an arrangement for vacuum coating which comprises a crucible in which organic material is heated and vaporized (WO 2006/061517 A1). Between this crucible and the coating chamber is disposed a valve with which vapor is controllable. The valve is here implemented as a horizontally movable gate valve.

An arrangement for coating a substrate has further been proposed, which includes a vapor valve comprised of quartz (US Application 12130118 of 30 May 2008).

The invention addresses the problem of providing an arrangement for high vacuum conditions, with which a gas stream or the like can be controlled with high precision without the material to be vaporized reacting with the material of the arrangement.

This problem is solved according to the features of patent claims 1 and19, respectively.

The advantage attained with the invention comprises in particular that by raising and lowering a valve tappet the injection rate of the valve, and therewith the vaporization rate, can be highly precisely regulated. Apart from the fast rate regulation in an inert environment, the arrangement also makes possible the connection of several vaporizer crucibles, which steam alternately, wherein the transition from one vaporizer crucible to the succeeding vaporizer crucible can virtually take place without production interruption through the slow opening or closing, respectively, of the particular valves. Essential structural parts of the arrangement are comprised of quartz so that these parts do not react with the material to be vaporized.

The invention relates thus to an arrangement for the regulation of a gas stream or the like, comprising:
- at least one vaporizer crucible for vaporizing a material or at least one supply container with material vapor,
- a vapor conduit which conducts the vaporized material or the material vapor to a substrate,
- a dosing pipe which connects the at least one vaporizer crucible or the at least one supply container with the vapor conduit,
- a tappet which projects into the dosing pipe as well as
- a regulator which regulates the position of the tappet in the dosing pipe as a function of a measured variable.

The invention further relates to a method for the regulation of a gas stream or the like comprising the steps:
- providing at least one vaporizer crucible with the material to be vaporized or at least one supply container with material vapor for coating a substrate,
- connecting a dosing pipe with the at least one vaporizer crucible or the at least one supply container via a vapor conduit,
- acquiring a measured variable proportional to the vapor pressure in the vapor conduit succeeding a regulating valve,
- regulating to a constant value the vapor stream introduced into the succeeding vapor conduit with the regulating valve, wherein the position of a tappet in the dosing pipe is regulated as a function of the measured variable, and
- conducting a material vapor from the vaporizer crucible or from the supply container via the vapor conduit to the substrate, wherein the material vapor is deposited on the substrate and the substrate is coated.

An embodiment example of the invention is shown in the drawing and in the following will be described in further detail. In the drawing depict:
- Fig. 1: a view of a valve regulation together with parts of a vacuum coating chamber,
- Fig. 2: a segment from Figure 1,
- Fig. 3: an isolated representation of a valve,
- Fig. 4: a segment of a variant of the vacuum chamber depicted in Figure 2 along section line A-A,
- Fig. 5: a variant of the vacuum chamber depicted in Figure 2,
- Fig. 6: a depiction in the form of a graph of the dependence of the coating rate on the level of a valve tappet.

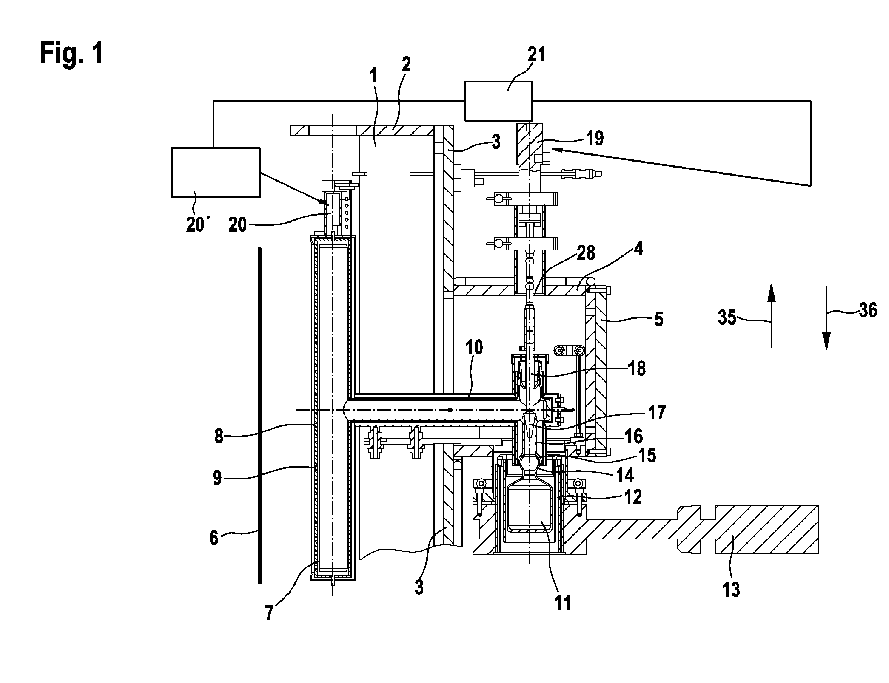

Figure 1 shows a subregion of a vacuum chamber 1 delimited by walls 2 to 5. In this vacuum chamber 1 is located a substrate 6, for example a glass sheet, which is to be coated with a substance, for example an organic substance, to produce, for example OLEDs (OLEDs = Organic Light Emitting Diodes). The substrate 6 is preferably coated with small organic molecules, in order to produce, for example, SMOLEDs (SMOLEDs = Small Molecules Organic Light Emitting Diodes) or organic thin layer solar cells. The coating takes preferably place in high vacuum. The coating takes place via a vertical conduit pipe 7 which is provided with several linearly arranged holes 8, 9 and is connected with a conduit pipe 10. The conduit pipe 10, together with the vertical conduit pipe 7, forms a vapor conduit 7, 10, by means of which the vapor is conducted in the direction toward the substrate. The conduit pipe 10 is coupleable with its one end with a supply container, for example a vaporizer crucible 11, which is encompassed by a heater. In this vaporizer crucible 11 is disposed the material to be vaporized. Instead of the vaporizer crucible 11, a supply container is also conceivable in which hot organic vapor is contained, which can be fed in various ways. The vaporizer crucible 11 can be isolated off from the vacuum chamber 1 by means of a gate valve 13. The vaporizer crucible 11 includes in its upper region a cupola-shaped formation 14, which can be closed on its topside with a calotte-shaped termination 15. This termination 15 is connected with a dosing pipe 16 which transitions over into the conduit pipe 10. Into the dosing pipe 16 projects a conical closure or tappet 17 which forms the end of a rod 18, which is vertically movable, i.e. in the direction of arrows 35 and 36, respectively. For the vertical movement a drive 19, only shown schematically, is provided, which via a vacuum lead-through, acts on the rod 18. The rate of the vaporizer material serving for the coating is acquired by means of a measuring instrument 20, 20' and supplied to a regulator 21, preferably a PID regulator. This PID regulator controls the schematically shown drive 19 such that the conical closure or tappet 17 can be moved upwardly or downwardly whereby more or less vaporized material is conducted into the conduit pipe 10. It is evident to a person of skill in the art that the tappet 17 can also have a different form provided it can close off the dosing pipe 16. The drive 19, the tappet 17 and the rod 18, consequently, form a regulating valve 17, 18, 19.

In principle, to the conduit pipe 10 several vaporizer crucibles can also be connected simultaneously. However, in this case it is necessary that each of these vaporizer crucibles is connected to a regulating valve comprised of a drive and a tappet connected by a rod to the drive. As is also the case in the vaporizer crucible 11, each of these vaporizer crucibles comprises a gate valve 13. In these vaporizer crucibles, in this case, different or identical materials to be vaporized can be contained. Since these vaporizer crucibles also include a heating device independent of one another, the vaporizer crucibles can be alternately connected to the vacuum chamber and the material disposed in them be vaporized. Herein the coating process does not need to be interrupted. Since each vaporizer crucible includes a gate valve, the vaporizer crucibles can therewith be isolated off from the vacuum chamber independently of one another. Replenishing the vaporizer crucibles with material proves therewith to be simple. Via the particular regulating valve, consequently, materials can also be vaporized from one or simultaneously from several vaporizer crucibles. Several vaporizer crucibles can thus also determine the vaporization rate simultaneously. By slowly opening a regulating valve of a first vaporizer crucible and simultaneously slowly closing a regulating valve of a second vaporizer crucible the vaporization can be switched to another vaporizer crucible without interrupting the production.

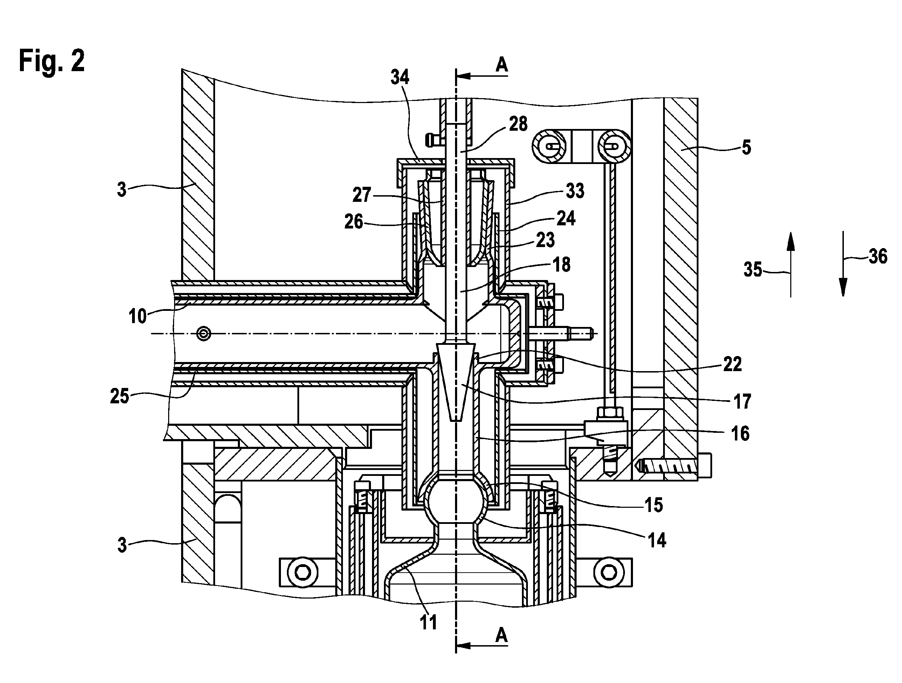

Figure 2 shows a segment from Figure 1 at an enlarged scale. Evident is here a portion of the vaporizer crucible 11 with the cupola-shaped formation 14 and the calotte-shaped termination 15, wherein the calotte-shaped termination 15 forms the one end of the dosing pipe 16. This dosing pipe 16 opens into the conduit pipe 10. At the opening site the conduit pipe 10 includes an annular inwardly directed sealing extension 22, which can be conically ground. In contact on this sealing extension 22 is the downwardly directed conical tappet 17, which is also provided with a ground sealing face, and which tappet has here the form of a cone. Tappet 17 and sealing extension 22 together form a valve. This valve 17, 22 in the arrangement shown in Figure 2 is in the closed vapor-tight state. The base of the tappet 17 forms a unit with the rod 18, and this rod 18 can be moved by the drive 19, shown schematically in Figure 1, vertically, i.e. in the direction of arrows 35, 36. This drive 19 can be an hydraulic or pneumatic drive with a cylinder and a piston, wherein the piston at higher pressure in the cylinder migrates downwardly and at lower pressure migrates upwardly. However, as a drive can also be provided an electromotor, whose rotational movement is converted via a gearing into a linear movement. However, an electro-linear drive is preferably utilized.

All of the parts of the arrangement depicted in Figure 2 which come into contact with vapor, are comprised of a material which is inert against this vapor, for example quartz glass, and are heated. In the arrangement depicted in Figure 2 the conduit pipe 10, the vaporizer crucible 11, the formation 14, the termination 15, the dosing pipe 16, the tappet 17, the rod 18, the sealing extension 22 as well as tubular fitting 23 can be comprised of quartz glass. The vertical conduit pipe 7, not depicted in Figure 2, can also be comprised of quartz glass.

For the heating are provided a heater 24, for example heating jackets 24, and an outer shielding 33, which is intended to reflect the thermal radiation. The valve 17, 22 is consequently heated indirectly through thermal radiation. Hereby the vapor does not condense on valve 17, 22. Due to its lower coefficient of thermal expansion, the quartz glass of which the valve 17, 22 is preferably comprised, expands minimally. Mechanical problems, for example the seizing of the valve 17, 22, are hereby prevented.

The conduit pipe 10, which is to be considered as a part of a gas distribution system, comprises an upwardly directed tubular fitting 23, preferably of quartz, which on its inner wall is provided with a conical ground joint. The conduit pipe 10 is completely encompassed by a heater 25, which is characterized by a homogeneously distributed temperature. The entire unit is encompassed by the shielding 33, which reflects the thermal radiation toward the gas distribution system 10, 16. A cover 34 serves also for the reflection of the thermal radiation.

Into the conical ground joint of the fitting 23 in the upper region of the conduit pipe 10 is set a connection piece 26 such that it forms a vapor seal. This connection piece 26 has on its inside a ground-in sealing and bearing face which encompasses the rod 18 upwardly forming a vapor seal.

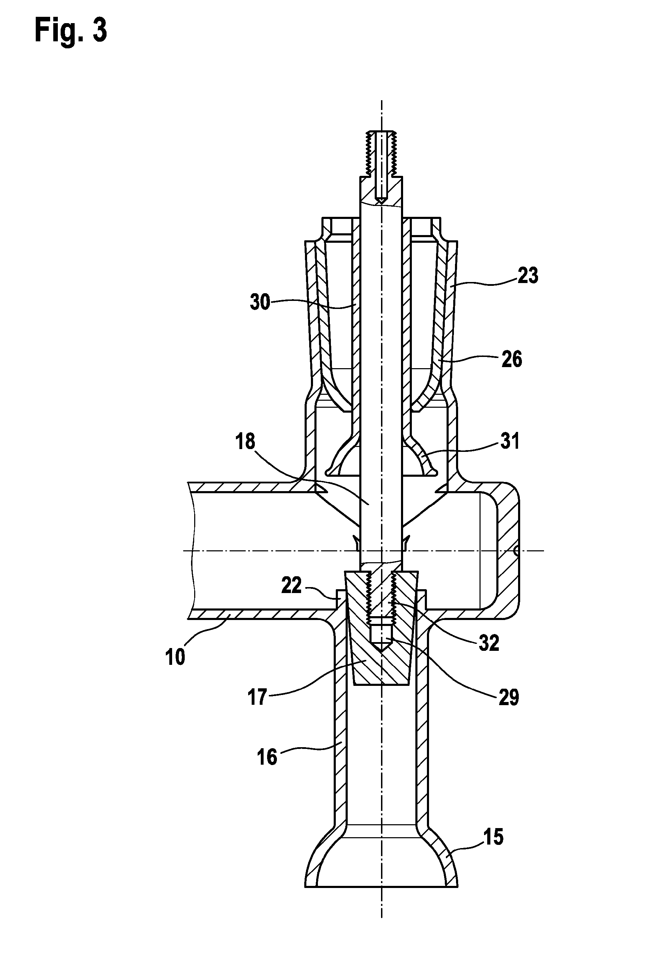

Figure 3 shows a variant of the valve in detail. Evident is here again the tappet 17, which here has the form of a truncated cone, as well as the rod 18. This rod 18 is here not a part of the tappet 17, but rather projects with a tapering end 32 into a recess 29 of the tappet 17. This end 32 can be provided with threading, such that the tappet 17, which also includes threading, is replaceable. The rod 18 is encompassed by a tube 30, which encompasses the rod 18 and includes a calotte-shaped end 31. The cupola-shaped connection piece 26 is in contact with its outside on the inside of the tubular fitting 23 which is connected with the conduit pipe 10.

Rod 18 with the tapering end 32, tappet 17, the conduit pipe 10, the connection piece 26, the tube 30 with the calotte-shaped end 31, the termination 15 and the formation 14 are preferably comprised of quartz glass.

If quartz glass is utilized as the inert material, special constructions are required in order to arrive at a quasi-vapor-tight, yet movable, arrangement necessary for the valve unit. For this purpose serves, for example, the slightly conically formed termination of the upwardly guided tubular fitting 23 of the conduit pipe 10. The conduit pipe 10 can here be closed off by an also conically formed quartz stopper, which has a guide tube 27 (Fig. 2) or 30 (Fig. 3) for the rod 18, quasi-vapor-tight against the vacuum surrounding the arrangement. This is only successful if the complete valve unit is adequately heated. For this purpose temperatures are necessary on the valve, which exceed the vaporization temperatures selected for the vaporization crucible. Such temperatures are attained through heating jackets and outer shieldings, which serve as reflectors and are disposed in the vacuum chamber. However, such heating jackets and shieldings are not shown in Figure 3.

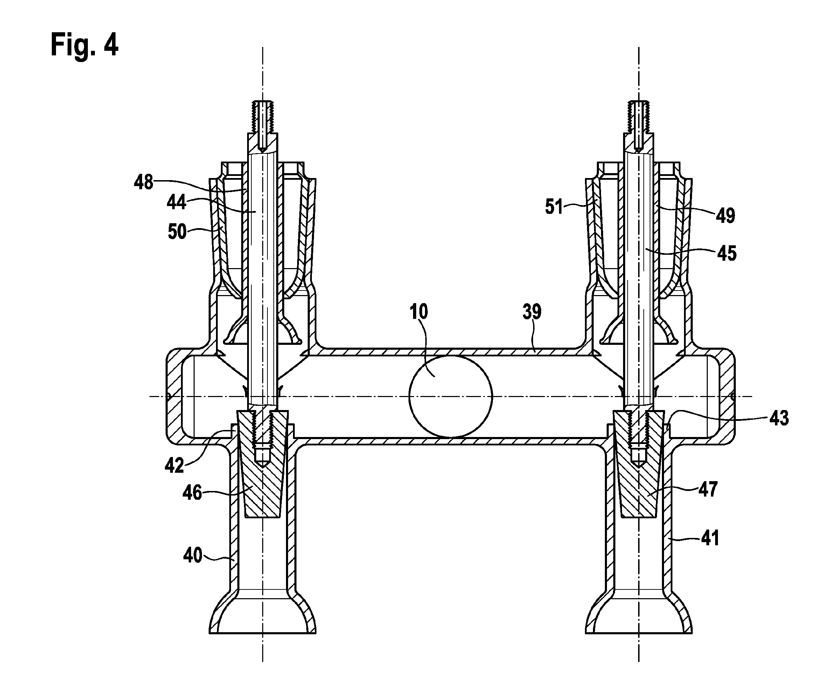

Figure 4 depicts a segment of a variant of the vacuum chamber 1 shown in Figure 2 along section line A-A, wherein tappets 46, 47 are provided which have the form of the tappet according to Figure 3. It is evident in this representation that two valves are provided. Evident is a tube 39 which is disposed on the conduit pipe 10. On this tube 39 are disposed two dosing pipes 40, 41, each of which has a sealing extension 42, 43. To each of these dosing pipes 40, 41 can be connected a vaporizer crucible or a supply container. Therewith, this variant of the vacuum chamber differs from the vacuum chamber 1 depicted in Figure 1 essentially only thereby that on the conduit pipe 10 two vaporizer crucibles or supply containers are disposed. Vaporizer crucibles or supply containers are, however, not shown in Figure 4. Evident are also two rods 44, 45, which are each inserted in the tappet 46, 47. Each of these two rods 44, 45 is herein disposed in a guide tube 48, 49, each of which is encompassed by a connection piece 50, 51. The tube 39, the dosing pipes 40, 41, the sealing extensions 42, 43, the rods 44, 45, the closures 46, 47 and the connection pieces 50, 51 are preferably comprised of quartz. With this configuration shown in Figure 4, thus, two different or also two identical materials can be vaporized. It is therewith obvious to a person of skill in the art that on the conduit tube 10 more than only two dosing pipes provided with valves can also be disposed.

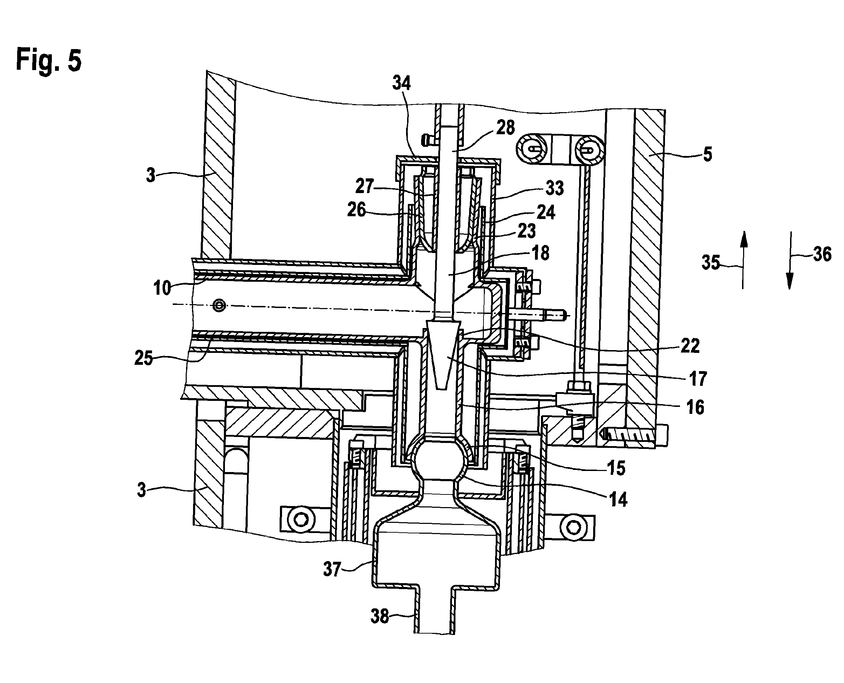

Figure 5 shows a variant of the vacuum chamber 1 depicted in Figure 2. This variant differs from the vacuum chamber 1 depicted in Figure 2 only thereby that, instead of a vaporizer crucible 11, a supply container 37 is disposed on the dosing pipe 16.

This supply container 37 is connected via a conduit 38, for example via a pipe or a hose, with a vapor or gas source. This vapor or gas source supplies the vacuum chamber 1 with the vapor or gas with which the substrate is to be coated. Such a vapor or gas source, however, is not shown in Figure 5. Like the vaporizer crucible 11 in Figure 2, the supply container 37 is also comprised of quartz. Therewith is prevented that the supply container 37 reacts with the vapor or the gas. The conduit 38 is also comprised of a material that does not react with the vapor or the gas. If, for example, the conduit 38 is a pipe, this pipe can also be comprised of quartz. The vaporization rate is therein again regulated via the opening level of the regulating valve. By means of the regulating valve it is also possible to equalize quickly potential pressure fluctuations in the supply container 37 such that the vaporization rate remains constant.

To allow the injection rate to rise slowly during the opening of the valve, it is basically possible to select any valve forms which, with the opening of the valve, are capable of continuously enlarging the opening and therewith increasing the throughflow quantity. The more precise the regulation has to be, the smaller must be the stages in which the valve opening is enlarged. In Figures 1 and 2 is shown a tappet 17, which has an opening angle of 10 degrees at a pipe diameter of 15 mm. However, other combinations of pipe diameter and opening angle between 0 and 90 degrees are also conceivable. It is only important that the valve tappet 17 can effect the best possible sealing of the valve, i.e. for example better than 1% of the vaporization rate. This can take place, for example, thereby that the maximal diameter of the valve tappet 17 is greater than the diameter of the pipe 16 or the sealing extension 22 or that the tappet 17 over a certain length has a very good fit with the dosing pipe 16. The smaller the opening angle, the more precise is the regulation of the throughflow. The throughflow set with the aid of the regulating valve can, as shown in Figure 4, be determined via a rate measurement and be regulated by means of the regulator.

As the measured variable can serve the vapor pressure of the vaporous material located in the vapor conduit 7, 10. Alternatively, a capacitive or optical signal proportional to the vapor pressure can be utilized. This vapor pressure is measured by means of a sensor, not shown in Figures 1, 2 and 3.

In Figure 1 the opening of the valve as a function of the measured pressure is regulated.

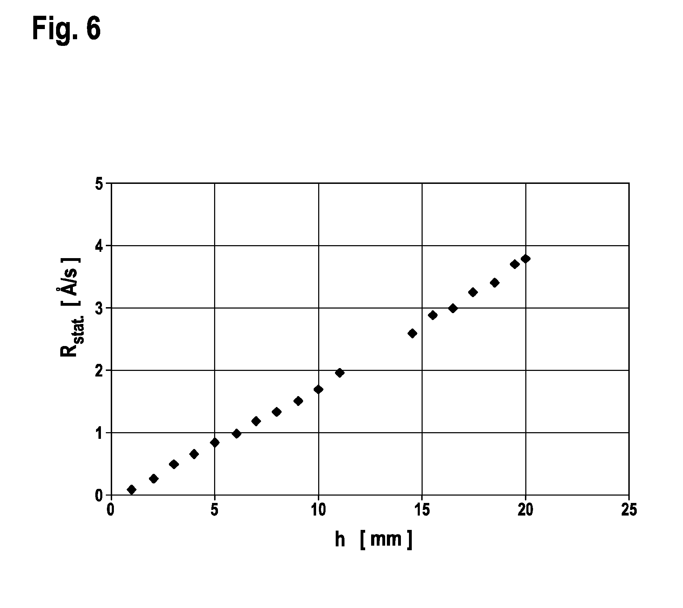

Figure 6 depicts a graph which shows the manner in which the vaporizer rate [Angstrom/second; 1 A/s = 0.1 nm/s = 10⁻¹⁰ m/s] is a function of the levels [h] of tappet 17. Tappet 17 has herein an opening angle of 10°. Evident is here a substantially linear dependence.

The regulation of a gas stream or the like by means of the arrangement depicted in the Figures can be carried out through the following steps:
a) providing at least one vaporizer crucible 11 with material to be vaporized or at least one supply container 37 with material vapor for coating a substrate 6,
b) connecting a dosing pipe 16, 40, 41 with the at least one vaporizer crucible 11 or the at least one supply container 37 via a vapor conduit 7, 10,
c) acquiring a measured variable proportional to the vapor pressure in the vapor conduit 7, 10 succeeding a regulating valve,
d) regulating to a constant value the vapor stream introduced into the succeeding vapor conduit 7, 10 utilizing the regulating valve, wherein the position of a tappet 17, 46, 47 in the dosing pipe 16, 40, 41 is regulated as a function of the measured variable,
e) conducting the material vapor from the vaporizer crucible 11 or from the supply container 37 via the vapor conduit 7, 10 to the substrate 6, wherein the material vapor is deposited on the substrate 6 and the substrate 6 is coated.

## Claims

1. Arrangement for the regulation of a gas stream or the like, comprising:
a) at least one vaporizer crucible (11) for the vaporization of a material or at least one supply container (37) with material vapor,
b) a vapor conduit (7, 10) which conducts the vaporized material or the material vapor to a substrate (6),
c) a dosing pipe (16, 40, 41) which connects the at least one vaporizer crucible (11) or the at least one supply container (37) with the vapor conduit (7, 10),
**characterized by**
d) a tappet (17, 46, 47) which projects into the dosing pipe (16, 40, 41),
e) a regulator (21) which regulates the position of the tappet (17, 46, 47) in the dosing pipe (16, 40, 41) as a function of a measured variable.

2. Arrangement as claimed in claim 1, **characterized in that** the tappet (17, 46, 47) has a conical form.

3. Arrangement as claimed in claim 2, **characterized in that** the tappet (17, 46, 47) has the form of a truncated cone or of a cone.

4. Arrangement as claimed in claim 1, **characterized in that** the vaporizer crucible (11) or the supply container (37) and the tappet (17, 46, 47) can be heated.

5. Arrangement as claimed in claim 1, **characterized in that** the measured variable characterizes the rate of the vaporizer material impinging on the substrate (6).

6. Arrangement as claimed in claim 1, **characterized in that** the measured variable is the pressure of the material vapor in the vapor conduit (7, 10).

7. Arrangement as claimed in claim 1, **characterized in that** the vapor conduit (7, 10) comprises a conduit pipe (10) with a tubular projection (22) which continues the dosing pipe (16, 40, 41) in the upward direction.

8. Arrangement as claimed in claim 7, **characterized in that** the conduit pipe (10) is provided with a tubular fitting (23), which encompasses a guide tube (27, 30) for a rod (18), wherein at the one end of this rod (18) the tappet (17, 46, 47) is provided.

9. Arrangement as claimed in claim 1, **characterized in that** at least one heater (24) is provided, which heats the tappet (17, 46, 47) by means of thermal radiation.

10. Arrangement as claimed in claim 9, **characterized in that** the heater (24) is encompassed by a reflector (33) which reflects the heat in the direction toward the tappet (17, 46, 47).

11. Arrangement as claimed in claim 1, **characterized in that** the conduit pipe (10) is encompassed by a heating jacket (25).

12. Arrangement as claimed in claim 1, **characterized in that** the dosing pipe (16, 40, 41) is stationary and the at least one vaporizer crucible (11) or the supply container (37) is detachable from the dosing pipe (16, 40, 41).

13. Arrangement as claimed in claim 1, **characterized in that** the tappet (17, 46, 47) is connected via a rod (18, 44, 45) with a drive (19).

14. Arrangement as claimed in claim 8, **characterized in that** between the tubular fitting (23) and the guide tube (27, 30) a connection piece (26) is disposed.

15. Arrangement as claimed in claim 1, **characterized in that** by opening a regulating valve (17, 18, 19) the penetration area for the material to be vaporized is enlarged.

16. Arrangement as claimed in claim 11, **characterized in that** the heater (24, 25) heats the vaporizer crucible (11) or the supply container (37), the vapor conduit (7, 10) and the dosing pipe (16, 40, 41).

17. Arrangement as claimed in claim 7, **characterized in that** the tubular projection (22) is a sealing extension.

18. Arrangement as claimed in claims 1 to 17, **characterized in that** the dosing pipe (16, 40, 41), the vaporizer crucible (11) or the supply container (37), respectively, the vapor conduit (7, 10), the tappet (17, 46, 47), the rod (18, 44, 45), the projection (22), the fitting (23), the guide tube (30), the connection piece (26) and the tubular projection (22) are comprised of quartz.

19. Method for the regulation of a gas stream or the like with the steps:
a) providing at least one vaporizer crucible (11) with material to be vaporized or at least one supply container (37) with material vapor for coating a substrate (6),
b) connecting a dosing pipe (16, 40, 41) with the at least one vaporizer crucible (11) or the at least one supply container (37) via a vapor conduit (7, 10),
c) acquiring a measured variable proportional to the vapor pressure in the vapor conduit (7, 10) succeeding a regulating valve (17, 18, 19),
d) regulating to a constant value the vapor stream introduced into the succeeding vapor conduit (7, 10) utilizing the regulating valve (17, 18, 19), wherein the position of a tappet (17, 46, 47) in the dosing pipe (16, 40, 41) is regulated as a function of the measured variable,
e) conducting the material vapor from the vaporizer crucible (11) or from the supply container (37) via the vapor conduit (7, 10) to the substrate (6), wherein the material vapor is deposited on the substrate (6) and the substrate (6) is coated.

## Amended claims

### Amended claims in accordance with Rule 137(2) EPC.

**1.** Arrangement for the regulation of a gas stream or the like, comprising:
a) at least one vaporizer crucible (11) for the vaporization of a material or at least one supply container (37) with material vapor,
b) a vapor conduit (7, 10) which conducts the vaporized material or the material vapor to a substrate (6),
c) a dosing pipe (16, 40, 41) which connects the at least one vaporizer crucible (11) or the at least one supply container (37) with the vapor conduit (7, 10),
d) a tappet (17, 46, 47) which projects into the dosing pipe (16, 40, 41),
e) a regulator (21) which regulates the position of the tappet (17, 46, 47) in the dosing pipe (16, 40, 41) as a function of a measured variable,
**characterized in that**
f) a vaporizer rate which is substantially linear to the height (h) of the tappet (17, 46, 47).

**2.** Arrangement as claimed in claim 1, **characterized in that** the tappet (17, 46, 47) has a conical form.

**3.** Arrangement as claimed in claim 2, **characterized in that** the tappet (17, 46, 47) has the form of a truncated cone or of a cone.

**4.** Arrangement as claimed in claim 1, **characterized in that** the vaporizer crucible (11) or the supply container (37) and the tappet (17, 46, 47) can be heated.

**5.** Arrangement as claimed in claim 1, **characterized in that** the measured variable characterizes the rate of the vaporizer material impinging on the substrate (6).

**6.** Arrangement as claimed in claim 1, **characterized in that** the measured variable is the pressure of the material vapor in the vapor conduit (7, 10).

**7.** Arrangement as claimed in claim 1, **characterized in that** the vapor conduit (7, 10) comprises a conduit pipe (10) with a tubular projection (22) which continues the dosing pipe (16, 40, 41) in the upward direction.

**8.** Arrangement as claimed in claim 7, **characterized in that** the conduit pipe (10) is provided with a tubular fitting (23), which encompasses a guide tube (27, 30) for a rod (18), wherein at the one end of this rod (18) the tappet (17, 46, 47) is provided.

**9.** Arrangement as claimed in claim 1, **characterized in that** at least one heater (24) is provided, which heats the tappet (17, 46, 47) by means of thermal radiation.

**10.** Arrangement as claimed in claim 9, **characterized in that** the heater (24) is encompassed by a reflector (33) which reflects the heat in the direction toward the tappet (17, 46, 47).

**11.** Arrangement as claimed in claim 1, **characterized in that** the conduit pipe (10) is encompassed by a heating jacket (25).

**12.** Arrangement as claimed in claim 1, **characterized in that** the dosing pipe (16, 40, 41) is stationary and the at least one vaporizer crucible (11) or the supply container (37) is detachable from the dosing pipe (16, 40, 41).

**13.** Arrangement as claimed in claim 1, **characterized in that** the tappet (17, 46, 47) is connected via a rod (18, 44, 45) with a drive (19).

**14.** Arrangement as claimed in claim 8, **characterized in that** between the tubular fitting (23) and the guide tube (27, 30) a connection piece (26) is disposed.

**15.** Arrangement as claimed in claim 1, **characterized in that** by opening a regulating valve (17, 18, 19) the penetration area for the material to be vaporized is enlarged.

**16.** Arrangement as claimed in claim 11, **characterized in that** the heater (24, 25) heats the vaporizer crucible (11) or the supply container (37), the vapor conduit (7, 10) and the dosing pipe (16, 40, 41).

**17.** Arrangement as claimed in claim 7, **characterized in that** the tubular projection (22) is a sealing extension.

**18.** Arrangement as claimed in claims 1 to 17, **characterized in that** the dosing pipe (16, 40, 41), the vaporizer crucible (11) or the supply container (37), respectively, the vapor conduit (7, 10), the tappet (17, 46, 47), the rod (18, 44, 45), the projection (22), the fitting (23), the guide tube (30), the connection piece (26) and the tubular projection (22) are comprised of quartz.

**19.** Method for the regulation of a gas stream or the like with the steps:
a) providing at least one vaporizer crucible (11) with material to be vaporized or at least one supply container (37) with material vapor for coating a substrate (6).
b) connecting a dosing pipe (16, 40, 41) with the at least one vaporizer crucible (11) or the at least one supply container (37) via a vapor conduit (7, 10),
c) acquiring a measured variable proportional to the vapor pressure in the vapor conduit (7, 10) succeeding a regulating valve (17, 18, 19),
d) regulating to a constant value the vapor stream introduced into the succeeding vapor conduit (7, 10) utilizing the regulating valve (17, 18, 19), wherein the position of a tappet (17, 46, 47) in the dosing pipe (16, 40, 41) is regulated as a function of the measured variable,
e) conducting the material vapor from the vaporizer crucible (11) or from the supply container (37) via the vapor conduit (7, 10) to the substrate (6), wherein the material vapor is deposited on the substrate (6) and the substrate (6) is coated,
**characterized in that**
f) a vaporizer rate is provided which is substantially linear to the height (h) of the tappet (17, 46, 47).
